Europäisches Patentamt

European Patent Office

Office européen des brevets

(19)

(11) **EP 1 465 351 A2**

(12) **EUROPEAN PATENT APPLICATION**

(43) Date of publication:
**06.10.2004 Bulletin 2004/41**

(51) Int Cl.$^7$: **H03M 13/05**, H03M 13/45

(21) Application number: **04007728.1**

(22) Date of filing: **30.03.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL LT LV MK**

(30) Priority: **31.03.2003 KR 2003020255**

(71) Applicant: **Samsung Electronics Co., Ltd.**
**Suwon-si, Gyeonggi-do (KR)**

(72) Inventors:
• **Park, Sung-Eun**
**Yeongtong-gu Suwon-si Gyeonggi-do (KR)**

• **Kim, Jae-Yoel**
**Yeongtong-gu Suwon-si Gyeonggi-do (KR)**
• **Park, Seong-Ill**
**Yeongtong-gu Suwon-si Gyeonggi-do (KR)**
• **Kim, Young-Kyun**
**Yeongtong-gu Suwon-si Gyeonggi-do (KR)**
• **Lee, Hyeon-Woo**
**Yeongtong-gu Suwon-si Gyeonggi-do (KR)**

(74) Representative: **Grünecker, Kinkeldey,**
**Stockmair & Schwanhäusser Anwaltssozietät**
**Maximilianstrasse 58**
**80538 München (DE)**

(54) **Soft decision decoding of error correcting block codes using the fast Hadamard transform**

(57) The application proposes an apparatus and a method for maximazing decoding performance by performing the soft decision decoding utilizing the inverse fast Hadamard transform (IFHT) even for block codes where the generator matrix does not include a basis of a Walsh code. In the apparatus, symbol position information for relocating each reception symbol is determined utilizing the block code generator matrix information having k rows and n columns and an IFHT size information for performing an IFHT for the reception sym-bols, each reception symbol is relocated as an input of an IFHT unit according to the determined symbol posi-tion information, the relocated symbols are input and the IFHT is performed for the symbols; and a codeword of the block code, which has a maximum correlation value from among result values obtained by performing the IFHT, is output as a decoding signal.

FIG.7

EP 1 465 351 A2

**Description**

**BACKGROUND OF THE INVENTION**

1. Field of the Invention

The present invention relates generally to an apparatus and a method for decoding an error correction code in a communication system, and more particularly to an apparatus and a method for decoding a block code having a predetermined information bit length and block length.

2. Description of the Related Art

Typically, a code division multiple access (CDMA) communication system performs an error correction to correct an error caused from noise occurring in a transmission channel. Commonly, a transmission side transmits a codeword obtained by encoding information bits through an error correction scheme (i.e., a coding scheme) to a reception side. The reception side receives the codeword transmitted from the transmission side and decodes the received codeword using a decoding scheme corresponding to the coding scheme applied by the transmission side. As a result, the codeword is restored to the original information bits.

The error correction method representatively used in the CDMA communication system includes two schemes: a method using a block code and a method using a trellis code. In the error correction method using the block code, additional bits (e.g., r bits) arc inserted into a predetermined length of transmission information bits (e.g., k bits) to encode the transmission information bits into a block code of n (n=k+r) bits, and the encoded block code is transmitted. In order to transmit the information bits of k bits, the transmission side transmits the block code of n bits, that is, the (n, k) block code. Then, the reception side receives the (n, k) block code transmitted from the transmission side, decodes the received (n, k) block code, and extracts the original information bits of k bits. Further, in order to improve the error correction capability in the error correction method of using the block code, the number of the additional bits increases.

When using the block code, the structures of an encoder and a decoder change according to the size of the codeword. Therefore, when block codes having lengths different from each other are used in the same system, the encoder and the decoder for the block codes having different lengths must be separately provided to the system.

Further, the block code includes a BCH code, a Reed-Solomon code, etc., and a hard decision decoding is performed for the block code by means of a Berlekamp-Massey algorithm, a euclidean algorithm, etc.

The error correction method using the trellis code does not segment the transmission information bits into blocks to process the segmented blocks, but encodes the transmission information bits, which are preset after having been sequentially input to a shift register, into the trellis code through a logic structure, to transmit the coded information bits.

A ratio of the number of output bits with respect to the input transmission information bits is called a coding rate. When the coding rate is 1/k, the transmission side encodes an information bit of one bit into output bits of k bits, and transmits the encoded output bits according to the coding rate.Then, the reception side receives the trellis code, the coding rate of which is 1/k, transmitted from the transmission side, decodes the received trellis code, and extracts the original information bits of k bits.

Also, in order to improve the error correction capability in the error correction method of using the trellis code, the coding rate must be reduced.

Further, the trellis code includes a convolutional code, a turbo code, etc., and a soft decision decoding is performed for the trellis code using a viterbi algorithm, etc.

As described above, the hard decision decoding is performed for the block code in the decoding process. In performing the hard decision decoding, a received signal is determined to be either 1 or -1, so that the decoding performance of the hard decision decoding is generally lower than that of the soft decision decoding.

Further, as described above, the soft decision decoding is performed for the trellis code in the decoding process. In the soft decision decoding, the received signal is determined according to a weighted value and the soft decision decoding is performed on the received signal, so that the decoding performance of the soft decision decoding is higher than that of the hard decision decoding. Generally, the soft decision decoding performance improves by about 2[dB], in comparison with the hard decision decoding. However, in contrast with the hard decision decoding, the soft decision does not perform the decoding by simply determining the received signal to be 1 or -1, but considers the weighted value to perform the decoding. Therefore, not only docs the operation amount in the decoding process greatly increase, but the complexity of the hardware also increases. Accordingly, the length of the received block is large, that is, when the number of bits exceeds a predetermined value, it is difficult to employ the soft decision decoding.

As described above, because the soft decision decoding is superior to the hard decision decoding, the CDMA communication system uses the block code for a control signal having a relatively short block length. However, for an information signal having a relatively long block length, the CDMA communication system performs the soft decision decoding by using the trellis code, that is, a convolutional code or a turbo code.

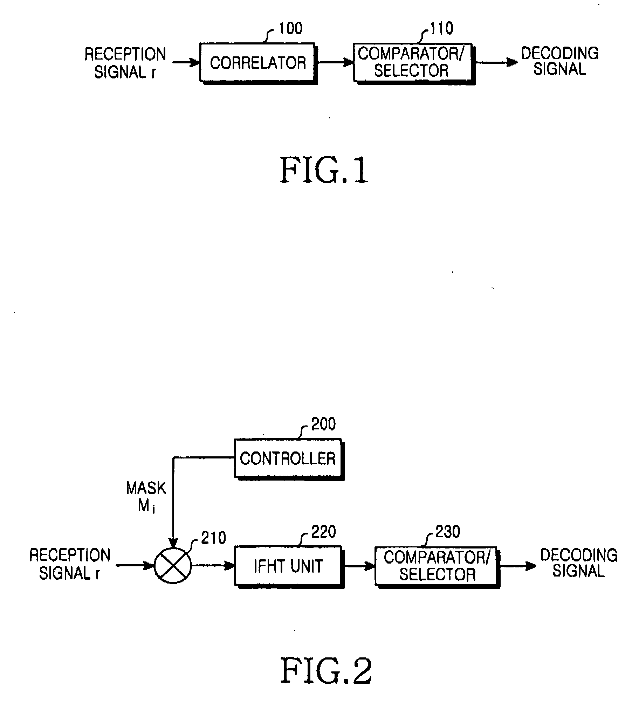

FIG. 1 is a block diagram illustrating an internal structure of a soft decision decoding apparatus using a general correlator. Referring to FIG. 1, a reception signal r received in a reception side is input to a correlator 100. Herein, it is assumed that a transmission side has transmitted a signal obtained by modulating a predetermined block code using a Binary Phase Shift Keying (BPSK) method. For instance, it is assumed the transmission side has transmitted a modulation signal of {+1, -1}. The reception signal r becomes a signal in which noise and interference are added to the modulation signal of {+1, -1} transmitted from the transmission side while the modulation signal experiences channel conditions (environments, situation, etc.). Accordingly, the signal r has a real value instead of the value of the signal of {+1, -1}.

The correlator 100 inputs the reception signal r to correlate the received signal r with respect to each codeword of the block code that can be transmitted from the transmission side of the communication system. The correlator 100 outputs correlation values between the received signal r and each codeword to a comparator/selector 110. The comparator/selector 110 compares the correlation values between the received signal r and each codeword with each other, selects a codeword having a maximum correlation value from the result of the comparison, and determines the selected codeword as the codeword transmitted from the transmission side. As a result, information bits corresponding to the codeword output from the comparator/selector 110 arc restored to original information bits.

For example, when the transmission side transmits a (n, k) block code, the reception side receives the reception signal r with real components. The reception signal r contains noise and interference in addition to the (n, k) block code. The signal r with the real component is provided to the correlator 100. The correlator 100 correlates the signal r to each codeword of the (n, k) block code that can be transmitted from the transmission side so as to output the correlation result to the comparator/selector 110.

In considering all codewords that can be generated from the (n, k) block code, $2^k$ codewords, each of which has a length of n, exist. Further, because the correlation must be performed with respect to each of the $2^k$ codewords, each of which has a length of n, n x $2^k$ multiplication processes and (n-1) x $2^k$ plus processes are necessary. For example, when it is assumed that the (n, k) block code is a (10, 3) block code, the total number of codewords that can be generated from the (10, 3) block code is eight and each of the codewords has length of 10. Further, because the correlation must be performed with respect to each of the eight codewords of the (10, 3) block code, 80 (10 x 8) multiplication processes and 72 (9 x 8) plus processes are necessary.

When the values of k and n increase, particularly, the value of k increases, the number of times of the multiplication processes and addition processes for performing the correlation increases by geometric progression. As a result, the performance of an entire system deteriorates due to a load in an operation process.

In a conventional block code, when the soft decision decoding is applied to the block code, k information bits have a limited length (e.g., below 14 bits). Therefore, the soft decision decoding may not be applied to the block code even though the performance of the soft decision decoding has an effect that is superior to that of the hard decision decoding.

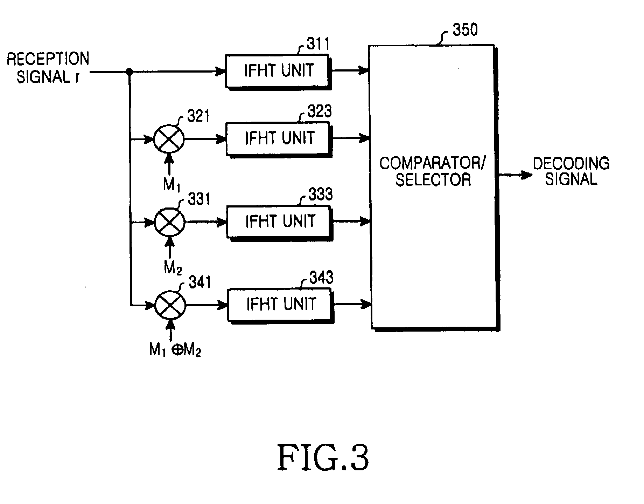

FIG 2 is a block diagram illustrating an internal structure of a soft decision decoding apparatus with a serial structure using a conventional inverse fast hadamard transform (IFHT) unit. However, before describing the apparatus with reference to FIG 2, the serial structure is a structure in which a mask M, to be described below is sequentially considered. In FIG 3, a soft decision decoding apparatus with a parallel structure using an IFHT unit will be described. In this case, the parallel structure represents a structure in which the mask $M_i$ is simultaneously processed.

Referring to FIG. 2, a reception signal r received in a reception side is input to a mask multiplier 210. Herein, a transmission side corresponding to the reception side transmits a block code, the generator matrix of which includes bases of a Walsh code. The mask multiplier 210 multiplies the signal r by the mask $M_i$ output from a controller 200, and outputs a signal obtained by the multiplication to an IFHT unit 220. The IFHT unit 220 inputs the signal output from the mask multiplier 210, performs the IFHT for the signal r, and outputs the result to a comparator/selector 230. Herein, because the soft decision decoding apparatus in FIG 2 has a serial structure and it is assumed that a mask is not initially applied, the controller 200 does not output the mask $M_i$.

The controller 200 sequentially outputs a corresponding mask $M_i$ to the mask multiplier 210. For example, when two masks $M_1$ and $M_2$ exist, the controller 200 does not initially apply the mask M,. Then, the controller 200 sequentially outputs the mask $M_1$ and the mask $M_2$, and an exclusive OR of the mask $M_1$ and the mask $M_2$, that is, $M_1 \oplus M_2$, to the mask multiplier 210.

The IFHT unit 220 sequentially performs the IFHT for all signals output from the mask multiplier 210, that is, a signal to which the mask is not applied (i.e., the signal r), a signal obtained by multiplying the signal r by the mask $M_1$, a signal obtained by multiplying the signal r by the mask $M_2$, and a signal obtained by multiplying the signal r by the exclusive OR ($M_1 \oplus M_2$) of the mask $M_1$ and the mask $M_2$. Then, the IFHT unit 220 outputs the result to the comparator/selector 230. The comparator/selector 230 compares all result values output from the IFHT unit 220 with each other, selects a codeword having a maximum correlation value, and determines the selected codeword as a codeword transmitted from a transmission side. As a result, information bits corresponding to the codeword output from the comparator/selector 230 are restored to the original information bits. An operation of the controller 200 and the mask multiplier 210 will be described in more detail herein below.

An (n, k) Reed-Muller code, for example, an (8, 3) Reed-Muller code, is shown below in Table 1.

Table 1

| Information bits | Codeword |
|---|---|
| 000 | 00000000 |
| 001 | 01010101 |
| 010 | 00110011 |
| 011 | 01100110 |
| 100 | 00001111 |
| 101 | 01011010 |
| 110 | 00111100 |
| 111 | 01101001 |

As shown in Table 1, the number of codewords of the (8, 3) Reed-Muller code that can be generated, when 3 information bits arc input, is $2^3$ or eight. When the information bits are 000, a codeword '00000000' is generated, when the information bits are 001, a codeword '01010101' is generated, when the information bits are 010, a codeword '00110011' is generated, when the information bits are Oil, a codeword '01100110' is generated, when the information bits are 100, a codeword '00001111' is generated, when the information bits are 101, a codcword '01011010' is generated, when the information bits are 110, a codeword '00111100' is generated, and when the information bits are 111, a codeword '01101001' is generated.

A generator matrix of the (8, 3) Reed-Muller code as shown in Table 1 is equal to Equation 1 below.

$$\text{Equation 1}$$
$$G \simeq \begin{bmatrix} 01010101 \\ 00110011 \\ 00001111 \end{bmatrix}$$

In equation 1, G represents the generator matrix. Because the number of rows is equal to the number k of input information bits and the number of columns is equal to the number n of output bits, a Reed-Muller code generated according to the generator matrix becomes the (8, 3) Reed-Muller code. Also, bccause each row of the generator matrix is a basis, three bases exist in the generator matrix.

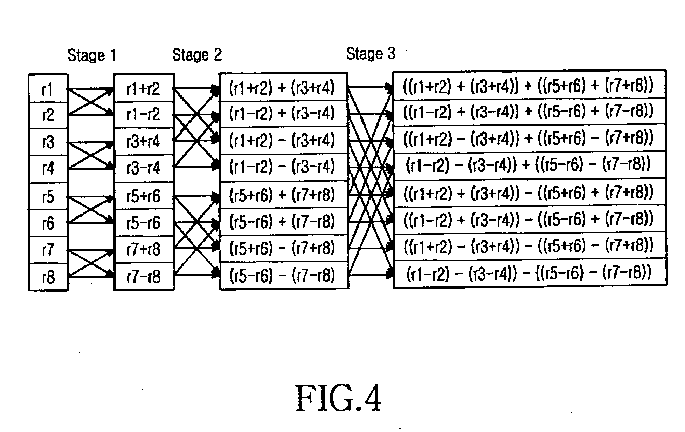

As indicated above, for the (8, 3) Reed-Muller code, eight codewords, each of which having a length of 8, exist. Further, IFHT must be performed with respect to each of the eight codewords. Hereinafter, a process by which the IFHT is performed for the (8, 3) Reed-Muller code will be described with reference to FIG. 4.

FIG 4 is a view schematically illustrating a process by which a conventional IFHT is performed. Referring to FIG. 4, because a reception signal r is a signal obtained from the codeword of the (8, 3) Reed-Muller code into which noise and interference are inserted, the reception signal r is expressed as r = r1r2r3r4r5r6r7r8, wherein r1 to r8 each is "reception symbols" hereinafter.

Further, in order to perform a 100% performance of soft decision decoding similar to that of the correlator 100 described with reference to FIG. 1, the IFHT unit 220 must consider a correlation between each of the codewords that can be generated from the (8, 3) Reed-Muller code and the reception signal r. As a result, performing the 100% performance of soft decision decoding means performing the correlation for each of the codewords which can be transmitted from the transmission side with respect to the reception signal r.

Further, the (8, 3) Reed-Muller code as shown in Table 1 is expressed by digital data. However, because the digital data is modulated by a predetermined method, for example, a BPSK method, on the air, the digital data is transmitted in a state in which the digital data 0 corresponds to +1 and the digital data 1 corresponds to -1. Accordingly, when the (8, 3) Reed-Muller code shown in Table 1 corresponds to components modulated by the BPSK method, Table 2 is obtained.

Table 2

| Information bits | Components of codeword modulated by BPSK method |
|---|---|
| 000 | + + + + + + + + |
| 001 | + - + - + - + - |
| 010 | + + - - + + - - |
| 011 | + - - + + - - + |
| 100 | + + + + - - - - |
| 101 | + - + - - + - + |
| 110 | + + - - - - + + |
| 111 | + - - + - + + - |

For 100 % of soft decision decoding, a correlation for each codeword modulated by the BPSK method as shown in Table 2 with respect to the reception signal r (i.e., r1r2r3r4r5r6r7r8) must be performed. When the IFHT is performed, it is possible to perform the correlation for each of the codewords modulated by the BPSK method with respect to the reception signal r, because the IFHT using a butterfly logic structure as illustrated in FIG. 4 is performed.

More specifically, when stages are performed as many as k (the number of input information bits) times, that is three times, with respect to the reception signal r1r2r3r4r5r6r7r8 by the exponentiation of 2, it is possible to perform the correlation for each of the codewords modulated by the BPSK method. Herein, each stage performs a plus operation and a minus operation with respect to each component of the reception signal r by the exponentiation of 2. The first stage performs a plus (or addition) operation and a minus (or subtraction) operation with respect to each component of the reception signal r by the $2^0$ (1). That is, r1 and r2 are subjected to a plus operation and a minus operation, r3 and r4 are subjected to a plus operation and a minus operation, r5 and r6 are subjected to a plus operation and a minus operation, and r7 and r8 are subjected to a plus operation and a minus operation.

The second stage performs a plus operation and a minus operation with respect to each component from the result of the first stage, that is, r1+r2, r1-r2, r3+r4, r3-r4, r5+r6, r5-r6, and r7+r8, r7-r8, by the $2^1$ (2). More specifically, r1+r2 and r3+r4 are subject to a plus operation and a minus operation, r1-r2 and r3-r4 are subject to a plus operation and a minus operation, r5+r6 and r7+r8 are subject to a plus operation and a minus operation, and r5-r6 and r7-r8 are subject to a plus operation and a minus operation.

The third stage performs a plus operation and a minus operation with respect to each component from the result of the second stage, that is, (r1+r2)+(r3+r4), (r1-r2)+(r3-r4), (r1+r2)-(r3+r4), (r1-r2)-(r3-r4), (r5+r6)+(r7+r8), (r5-r6)+(r7-r8), (r5+r6)-(r7+r8), (r5-r6)-(r7-r8), by the $2^2$ (4). More specifically, (r1+r2)+(r3+r4) and (r5+r6)+(r7+r8) are subject to a plus operation and a minus operation, (r1-r2)+(r3-r4) and the (r5-r6)+(r7-r8) are subject to a plus operation and a minus operation, (r1+r2)-(r3+r4) and (r5+r6)-(r7+r8) are subject to a plus operation and a minus operation, and (r1-r2)-(r3-r4) and (r5-r6)-(r7-r8) are subject to a plus operation and a minus operation.

According to a result performed from the first stage to the third stage in this way, one can see that a correlation for each codeword modulated by the BPSK method as described in Table 2 with respect to the reception signal r1r2r3r4r5r6r7r8 has been performed. That is, a correlation result for the first codeword (i.e., ++++++++) modulated by the BPSK method in table 2 with respect to the reception signal r1r2r3r4r5r6r7r8 is a {(r1+r2)+(r3+r4)}+{(r5+r6)+(r7+r8)}, a correlation result for the second codeword (i.e., +-+-+-+-) with respect to the reception signal r1r2r3r4r5r6r7r8 is a {(r1-r2)+(r3-r4)}+{(r5-r6)+(r7-r8)}, a correlation result for the third codeword (i.e., ++--++--) with respect to the reception signal r12r3r4r5r6r7r8 is a {(r1+r2)-(r3+r4)}+{(r5+r6)-(r7+r8)}, a correlation result for the fourth codeword (i.e., +--++--+) with respect to the reception signal r1r2r3r4r5r6r7r8 is a {(r1-r2)-(r3-r4)}+{(r5-r6)-(r7-r8)}, a correlation result for the fifth codeword (i.e., ++++----) with respect to the reception signal r1r2r3r4r5r6r7r8 is a {(r1+r2)+(r3+r4)}-{(r5+r6)+(r7+r8)}, a correlation result for the sixth codeword (i.e., +-+--+-+) with respect to the reception signal r1r2r3r4r5r6r7r8 is a {(r1-r2)+(r3-r4))-{(r5-r6)+(r7-r8)}, a correlation result for the seventh codeword (i.e., ++----++) with respect to the reception signal r1r2r3r4r5r6r7r8 is a {(r1+r2)-(r3+r4)}-{(r5+r6)-(r7+r8)}, and a correlation result for the eighth codeword (i.e., +--+-++-) with respect to the reception signal r1r2r3r4r5r6r7r8 is a {(r1-r2)-(r3-r4)}-{(r5-r6)-(r7-r8)}. As a result, the correlation for the codewords of the (8, 3) Reed-Muller code modulated by the BPSK method in Table 2 with respect to the reception signal r1r2r3r4r5r6r7r8 has been 100% performed.

When considering an operation amount according to the implementation of the IFHT for the (8, 3) Reed-Muller code, 24 ($8\log_2 8$) total (plus operation, minus operation) processes, that is, eight plus processes at the first stage, eight plus processes at the second stage, and eight plus processes at the third stage, are required through three ($\log_2 8$)

stages. Meanwhile, in view of the operation amount when correlating the (8, 3) Reed-Muller code through a correlator, 64 ($8 \times 2^3$) multiplication processes and 56 {$(8-1) \times 2^3$} plus processes are necessary.

Finally, when considering all codewords for the (n, k) block code, $2^k$ codewords, each of which have a length of n, exist. Further, because the correlation must be performed with respect to each of the $2^k$ codewords each of which having a length of n, n x $2^k$ multiplication processes and (n-1) x $2^k$ plus processes are necessary when performing the correlation through the correlator. However, when the IFHT is performed with respect to all codewords for the (n, k) block code, $nlog_2n$ plus processes are necessary. As a result, when the soft decision decoding is performed through the IFHT with respect to all block codes, 100% soft decision decoding considering the correlation is possible. In addition, the operation amount is minimized, and a performance of the soft decision decoding is maximized.

Applying a mask to a Reed-Muller code means a basis, which will be used as a mask, is added to a basis of a generator matrix. That is, as described above, the generator matrix has bases having the same number as that of input information bits. Herein, when the mask is applied, the generator matrix not only has bases having the same number as that of input information bits, but also has the basis to be used as the mask.

For example, when an all-one mask is applied to the (8, 3) Reed-Muller code as shown in Table 1, the generator matrix is equal to Equation 2 below.

### Equation 2

$$G = \begin{bmatrix} 01010101 \\ 00110011 \\ 00001111 \\ 11111111 \end{bmatrix}$$

In equation 2, G represents the generator matrix, and an all-one basis in the fourth row of the generator matrix in Equation 2 is a mask basis of the (8, 3) Reed-Muller code.

When the reception signal r is initially received, the controller 200 controls the mask M, not to be output on an assumption that a mask has not been applied. That is, the controller 200 controls the IFHT unit 220 to perform an IFHT with respect to the reception signal r. Herein, as described above, the controller 200 does not initially consider a mask, and then may consider the mask M, again. Also, when the mask is not applied, the controller 200 may output the mask $M_i$, all elements of which are constructed by 1s, to the mask multiplier 210 on an assumption that the all-one mask has been applied.

Even though the mask all elements of which are constructed by 1s is multiplied by the reception signal, variation docs not occur. Accordingly, the apparatus operates similarly to when the mask is not applied.

As described above, the mask, in which all elements are constructed by 1s, is used, so that a hardware structure formed when the mask is actually applied can be maintained in a way as to be identical to a hardware structure formed when the mask is not applied. However, because the mask has been actually applied to the reception signal r, the controller 200 outputs the mask $M_i$, which corresponds to the mask basis, to the mask multiplier 210. Herein, because the mask basis of the generator matrix is the all-one basis, all elements of the mask $M_i$ consist of 1s.

The mask multiplier 210 multiplies the reception signal r by the mask $M_i$ to output the multiplication result to the IFHT unit 220. Because the soft decision decoding apparatus illustrated in FIG. 2 has a serial structure, a case in which the mask vector $M_i$ is considered and a case in which the mask vector $M_i$ is not considered have been considered.

FIG. 3 is a block diagram illustrating an internal structure of a soft decision decoding apparatus with a parallel structure using a conventional IFHT unit. Referring to FIG. 3, a reception signal r received in a reception side is input to an IFHT unit 311 and a plurality of mask multipliers 321, 331, and 341. Further, the number of the mask multipliers provided in the reception side is determined according to the number of bases applied as a mask in a transmission side. In FIG. 3, it is assumed that the number of bases applied as the mask is two. Accordingly, the reception side includes a mask multiplier 321, a mask multiplier 331, and a mask multiplier 341. The mask multiplier 321 multiplies the reception signal r by a first mask $M_1$ corresponding to a first mask basis $m_1$, the mask multiplier 331 multiplies the reception signal r by a second mask $M_2$ corresponding to a second mask basis $m_2$, and the mask multiplier 341 multiplies the reception signal r by a mask corresponding to an exclusive OR of the first mask basis $m_1$ and the second mask basis $m_2$ (hereinafter, referred to as '$M_1 \oplus M_2$').

The IFHT unit 311 inputs the reception signal r, performs the IFHT with respect to the signal r, and outputs the implementation result to the comparator/selector 350. The mask multiplier 321 multiplies the reception signal r by the first mask $M_1$ to output the implementation result to an IFHT unit 323. The mask multiplier 331 multiplies the reception signal r by the second mask $M_2$ to output the implementation result to an IFHT unit 333. The mask multiplier 341 multiplies the reception signal r by the mask ($M_1 \oplus M_2$), so as to output the implementation result to an IFHT unit 343. Each of the IFHT units 323, 333, and 343 inputs signals output from the mask multipliers 321, 331, and 341, performs the IFHT for the signals, and outputs each of the results to the comparator/selector 350. The comparator/selector 350 compares the results output from each of the IFHT units 323, 333, and 343 and selects a codeword having a maximum correlation value to determine the selected codeword as a codeword transmitted from the transmission side. As a result, information bits corresponding to the codeword output from the comparator/selector 330 are restored as original information bits.

As described above, when considering all codewords for the (n, k) block code, $2^k$ codewords, each of which have a length of n, exist. Further, because the correlation must be performed with respect to each of the $2^k$ codewords each of which having a length of n, n x $2^k$ multiplication processes and (n-1) x $k^2$ plus processes are necessary when performing the correlation through the correlator. However, when the IFHT is performed with respect to all codewords for the (n, k) block code by means of the IFHT unit, only $n\log_2 n$ plus processes arc necessary, and the operation amount is minimized. As a result, the performance of the soft decision decoding is maximized. However, the soft decision decoding apparatus using the correlator described with reference to FIG. 1 can perform the soft decision decoding for a predetermined block codes, but the soft decision decoding apparatus using the IFHT unit described with reference to FIG. 2 can perform the soft decision decoding for only block codes a generator matrix of which includes a basis of a Walsh code. That is, the soft decision decoding apparatus using the IFHT unit can perform the soft decision decoding of minimizing the operation amount, but the block codes used as an object of the soft decision decoding must include the basis of the Walsh code.

## SUMMARY OF THE INVENTION

Accordingly, the present invention has been designed to solve the above-described problems occurring in the prior art, and a first object of the present invention is to provide an apparatus and a method for decoding an error correction code in a communication system.

A second object of the present invention is to provide an error correction code decoding apparatus and method having a minimum operation amount in a communication system.

A third object of the present invention is to provide an apparatus and a method for performing a soft decision decoding having a minimum operation amount for block codes having predetermined information bit length and block length.

A fourth object of the present invention is to provide an apparatus and a method for performing a soft decision decoding for predetermined block codes using an IFHT unit in a communication system.

In order to accomplish the above and other objects, according to one aspect of the present, there is provided an apparatus for decoding n reception symbols using block code generator matrix information having k rows and n columns comprising: a controller for determining symbol position information for relocating each reception symbol utilizing the block code generator matrix information and an IFHT size information for performing an IFHT for the reception symbols; a symbol arranging unit for relocating each reception symbol to an input of an IFHT unit according to the symbol position information determined by the controller; an IFHT unit for inputting the symbols relocated by the symbol arranging unit to perform the IFHT for the symbols; and a comparator/selector for outputting a codeword of the block code, which has a maximum correlation value from among result values obtained by performing the IFHT, as a decoding signal.

According to another aspect of the present, there is provided an apparatus for decoding a block code including n reception symbols utilizing block code generator matrix information having k rows and n columns comprising: a controller for determining an IFHT size information for performing an IFHT for the reception symbols and symbol position information for relocating each reception symbol utilizing the block code generator matrix information; a symbol arranging unit for relocating each reception symbol to an input of an IFHT unit according to the symbol position information determined by the controller; an IFHT unit for inputting the symbols relocated by the symbol arranging unit to perform the IFHT for the symbols; and a comparator/selector for outputting a codeword of the block code, which has a maximum correlation value from among result values obtained by performing the IFHT, as a decoding signal.

According to a further aspect of the present, there is provided an apparatus for decoding n reception symbols utilizing block code generator matrix information having k rows and n columns comprising: a controller for inputting the n reception symbols and calculating symbol positions for the n columns in the block code generator matrix; and a symbol arranging unit including adders which accumulate and relocate the n reception symbols at the calculated symbol positions.

According to yet another aspect of the present, there is provided a method for decoding n reception symbols utilizing block code generator matrix information having k rows and n columns comprising the steps of: a) determining symbol position information for relocating each reception symbol utilizing the block code generator matrix information and an IFHT size information for performing an IFHT for the reception symbols; b) relocating each reception symbol as an input of an IFHT unit according to the determined symbol position information; inputting the relocated symbols to perform the IFHT for the symbols; and c) outputting a codeword of the block code, which has a maximum correlation value from among result values obtained by performing the IFHT, as a decoding signal.

According to another aspect of the present, there is provided a method for decoding n reception symbols utilizing block code generator matrix information having k rows and n columns comprising the steps of: a) determining an IFHT size information for performing an IFHT for the reception symbols and symbol position information for relocating each reception symbol utilizing the block code generator matrix information; b) relocating each reception symbol as an input of an IFHT unit according to the determined symbol position information; c) inputting the relocated symbols to perform the IFHT for the symbols; and d) outputting a codeword of the block code, which has a maximum correlation value from among result values obtained by performing the IFHT, as a decoding signal.

According to another aspect of the present, there is provided a method for decoding n reception symbols utilizing block code generator matrix information having k rows and n columns comprising the steps of: operating symbol positions for the n columns in the block code generator matrix; and accumulating and relocating the n reception symbols at the operated symbol positions.

## BRIEF DESCRIPTION OF THE DRAWINGS

The above and other objects, features, and advantages of the present invention will be more apparent from the following detailed description taken in conjunction with the accompanying drawings, in which:

FIG. 1 is a block diagram illustrating an internal structure of a soft decision decoding apparatus using a conventional correlator;
FIG. 2 is a block diagram illustrating an internal structure of a soft decision decoding apparatus with a serial structure using a conventional IFHT;
FIG 3 is a block diagram illustrating an internal structure of a soft decision decoding apparatus with the parallel structure using a conventional IFHT unit;
FIG. 4 is a view schematically illustrating a process by which a conventional IFHT is performed;
FIG. 5 is a block diagram illustrating an internal structure of a soft decision decoding apparatus, which decodes a conventional punctured Reed-Muller code utilizing an IFHT unit;
FIG. 6 is a block diagram illustrating an internal structure of a soft decision decoding apparatus, which decodes a conventional repeated Reed-Muller code utilizing an IFHT unit;
FIG 7 is a block diagram illustrating an internal structure of a soft decision decoding apparatus using an IFHT unit according to a first embodiment of the present invention;
FIG 8 is a view schematically illustrating the symbol position information decision process by the controller 700 and the symbol relocation process by the symbol arranging unit 720 illustrated in FIG 7;
FIG. 9 is a view illustrating an internal structure of the symbol arranging unit 720 illustrated in FIG 7;
FIG. 10 is a block diagram illustrating an internal structure of a soft decision decoding apparatus using an IFHT unit according to a second embodiment of the present invention; and
FIG. 11 is a view schematically illustrating the symbol position information decision process by the controller 1000 and the symbol relocation process by the symbol arranging unit 1020 illustrated in FIG. 10.

## DETAILED DESCRIPTION OF THE PREFERRED EMBODIMENT

Hereinafter, preferred embodiments of the present invention will be described in detail with reference to the accompanying drawings. In the following description of the present invention, a detailed description of known functions and configuration incorporated herein will be omitted when it may make the subject matter of the present invention rather unclear.

As described above, a soft decision decoding using an inverse fast hadamard transform unit (IFHT unit) has the same soft decision performance as that of a soft decision decoding using a correlator. However, the soft decision decoding using the IFHT unit has a smaller operation amount (requires less actual operations) than that according to correlation implementation of the correlator, thereby minimizing the load of an operation process. However, because the soft decision decoding using the IFHT unit is only applicable to block codes, in which a generator matrix includes a basis of a Walsh code, the soft decision decoding using the IFHT unit cannot be frequently used even though it has performance superior to the soft decision decoding using the correlator.

Accordingly, the present invention proposes a scheme of maximizing decoding performance by performing the soft decision decoding utilizing the IFHT unit even for the block codes, the generator matrix of which does not include the basis of the Walsh code.

Before describing the characteristic of the IFHT, as described in the prior art, the block code including the basis of the Walsh code, that is, the Reed-Muller code will be described again. An (n, k) Reed-Muller code, for example, a (8, 3) Reed-Muller code, is identical to Table 1 described in the prior art. Herein, the k represents the length of input information bits and the n ($2^k$) represents the length of an output block. That is, as shown in Table 1, the number of codewords of the (8, 3) Reed-Muller code that can be generated, when the information bits of 3 bits are input, is $2^3$ (i. e., eight). When the information bits are 000, a codeword '00000000' is generated, when the information bits are 001, a codeword '01010101' is generated, when the information bits are 010, a codeword '00110011' is generated, when the information bits are 011, a codeword '01100110' is generated, when the information bits are 100, a codeword '00001111' is generated, when the information bits are 101, a codeword '01011010' is generated, when the information bits are 110, a codeword '00111100' is generated, and when the information bits are 111, a codeword '01101001' is generated. When each codeword of the (8, 3) Reed-Mullcr code is actually modulated by a method, for instance, a BPSK method, digital data 0 and 1 correspond to +1 and -1, respectively, to be transmitted on actual air.

When all codewords which can be generated from the (8, 3) Reed-Muller code arc modulated by the BPSK method, the codeword '00000000' is modulated into ++++++++, the codeword '01010101' is modulated into +-+-+-+-, the codeword '00110011' is modulated into ++--++--, the codeword '01100110' is modulated into +--++--+, the codeword '00001111' is modulated into ++++----, the codeword '01011010' is modulated into +-+--+-+, the codeword '00111100' is modulated into ++----++, and the codeword '01101001' is modulated into +--+-++-. Further, when each codeword that can be generated from the (8, 3) Reed-Muller code is modulated by the BPSK method, the modulation components are as shown below in Table 3.

Table 3

| + | + | + | + | + | + | + | + |
|---|---|---|---|---|---|---|---|
| + | - | + | - | + | - | + | - |
| + | + | - | - | + | + | - | - |
| + | - | - | + | + | - | - | + |
| + | + | + | + | - | - | - | - |
| + | - | + | - | - | + | - | + |
| + | + | - | - | - | - | + | + |
| + | - | - | + | - | + | + | - |

In table 3, a first row corresponds to a BPSK modulation component of the codeword '00000000', a second row corresponds to a BPSK modulation component of the codeword '01010101', a third row corresponds to a BPSK modulation component of the codeword '00110011', a fourth row corresponds to a BPSK modulation component of the codeword '01100110', a fifth row corresponds to a BPSK modulation component of the codeword '0000 1111', a sixth row corresponds to a BPSK modulation component of the codeword '01011010', a seventh row corresponds to a BPSK modulation component of the codeword '00111100', and an eighth row corresponds to a BPSK modulation component of the codeword '01101001'.

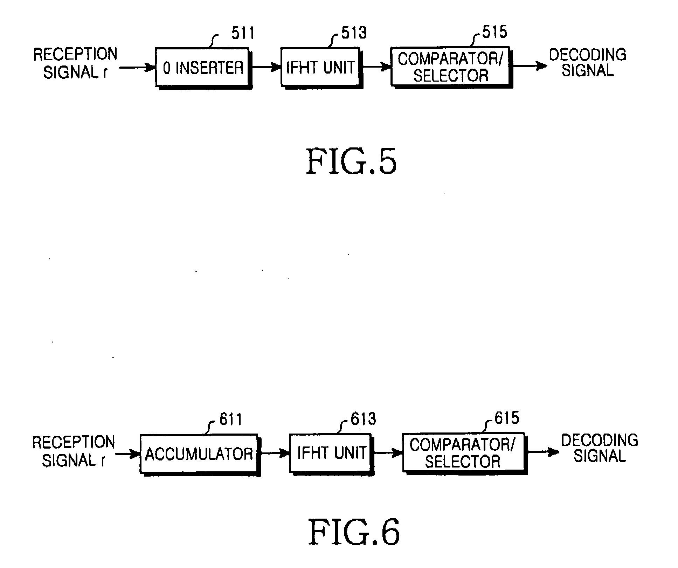

Hereinafter, a process by which the IFHT is performed for a punctured Reed-Muller code, that is, an (n-t, k) Reed-Muller code, for example, a (6, 3) Reed-Muller code obtained by puncturing predetermined 2 bits of an (8, 3) Reed-Muller code, will be described with reference to FIG. 5. Herein, the t represents the number of punctured bits.

FIG. 5 is a block diagram illustrating an internal structure of a soft decision decoding apparatus for decoding a conventional punctured Reed-Muller code utilizing an IFHT unit.

Before describing FIG. 5, the (6, 3) Reed-Muller code is obtained by puncturing the preceding two bits of each codeword of the (8, 3) Reed-Muller code described with reference to Table. 1. The (6, 3) Reed-Muller code is shown below in Table 4.

Table 4

| Information bits | Codeword |
|---|---|
| 000 | 000000 |
| 001 | 010101 |
| 010 | 110011 |
| 011 | 100110 |

Table 4   (continued)

| Information bits | Codeword |
| --- | --- |
| 100 | 001111 |
| 101 | 011010 |
| 110 | 111100 |
| 111 | 101001 |

Further, when each codeword that can be generated from the (6, 3) Reed-Muller code is modulated by the BPSK method, the modulation components are as shown in Table 5.

Table 5

| + | + | + | + | + | + |
| --- | --- | --- | --- | --- | --- |
| + | - | + | - | + | - |
| - | - | + | + | - | - |
| - | + | + | - | - | + |
| + | + | - | - | - | - |
| + | - | - | + | - | + |
| - | - | - | - | + | + |
| - | + | - | + | + | - |

Referring to FIG 5, a reception signal r is obtained from the (6, 3) Reed-Muller code into which noise and interference are inserted, and the reception signal r is expressed as r = r1r2r3r4r5r6. The reception signal r is transmitted to a 0 inserter 511. The 0 inserter 511 inputs the reception signal r, inserts 0 into a predetermined position, and then outputs the insertion result to an IFHT unit 513. Herein, the 0 inserter 511 inserts 0 into a position, at which a bit is punctured in the (8, 3) Reed-Muller code in a transmission side, and puncture position related information is known to the transmission side and a reception side.

The IFHT unit 513 inputs a signal output from the 0 inserter 511, performs the IFHT for the signal, and outputs the result to a comparator/selector 515. The comparator/selector 515 compares all IFHT result values output from the IFHT unit 513, and selects a codeword having a maximum correlation value to determine the selected codeword as a codeword transmitted from the transmission side. As a result, information bits corresponding to a codeword output from the comparator/selector 515 are restored to original information bits. Because the IFHT implementation process has been described in the prior art with reference to FIG. 4, a more detailed description thereof will be omitted.

Accordingly, in performing a soft decision decoding for the punctured (n-t, k) Reed-Muller code through the IFHT, the same result is obtained as when inserting '0's into bits located at punctured positions in the (n, k) Reed-Muller code and performing a soft decision decoding for the (n, k) Reed-Muller code through the IFHT. Also, for the soft decision decoding in the (n-t, k) Reed-Muller code, the same operation amount is necessary as that for the (n, k) Reed-Muller code.

As described above, the IFHT implementation for the punctured Reed-Muller code, that is, the (n-t, k) Reed-Muller code, has been described with reference to FIG 5. Hereinafter, a process, by which the IFHT is performed for a repeated Reed-Muller code, that is, a (n+t, k) Reed-Muller code, for example, a (10, 3) Reed-Muller code, obtained by repeating predetermined 2 bits of the (8, 3) Reed-Muller code, will be described with reference to FIG. 6. Herein, the t represents the number of repeated bits.

FIG. 6 is a block diagram illustrating an internal structure of a soft decision decoding apparatus for decoding a conventional repeated Reed-Muller code utilizing an IFHT unit.

However, before describing FIG. 6, the (10, 3) Reed-Muller code is obtained by repeating preceding two bits of each codeword of the (8, 3) Reed-Muller code described with reference to Table 1. The (10, 3) Reed-Muller code is shown below in Table 6.

Table 6

| Information bits | Codeword |
|---|---|
| 000 | 0000000000 |
| 001 | 0101010101 |
| 010 | 0011001100 |
| 011 | 0110011001 |
| 100 | 0000111100 |
| 101 | 0101101001 |
| 110 | 0011110000 |
| 111 | 0110100101 |

Further, when each codeword that can be generated from the (10, 3) Reed-Muller code is modulated by the BPSK method, the modulation components are as shown in Table 7.

Table 7

| + | + | + | + | + | + | + | + | + | + |
|---|---|---|---|---|---|---|---|---|---|
| + | - | + | - | + | - | + | - | + | - |
| + | + | - | - | + | + | - | - | + | + |
| + | - | - | + | + | - | - | + | + | - |
| + | + | + | + | - | - | - | - | + | + |
| + | - | + | - | - | + | - | + | + | - |
| + | + | - | - | - | - | + | + | + | + |
| + | - | - | + | - | + | + | - | + | - |

Referring to FIG. 6, a reception signal r is a signal obtained from the (10, 3) Reed-Muller code into which noise and interference are inserted. The reception signal r is expressed as r = r1r2r3r4r5r6r7r8r9r10. The reception signal r is transmitted to an accumulator 611. The accumulator 611 accumulates 2 bits from a Least Significant Bit (LSB) of the transmitted reception signal r and 2 bits from a Most Significant Bit (MSB) of the transmitted reception signal r, and outputs the accumulated result to an IFHT unit 613. Herein, the accumulator 611 accumulates bits at repeated positions in the (8, 3) Reed-Muller code in a transmission side, and repetition position related information is known to the transmission side and a reception side.

The IFHT unit 613 inputs a signal output from the accumulator 611, performs the IFHT for the signal, and outputs the result to a comparator/selector 615. The comparator/selector 615 compares all IFHT result values output from the IFHT unit 613, and selects a codeword having a maximum correlation value to determine the selected codeword as a codeword transmitted from the transmission side. As a result, information bits corresponding to a codeword output from the comparator/selector 615 are restored as original information bits. Because the IFHT implementation process_has been described in the prior art with reference to FIG. 4, a more detailed description will be omitted.

Accordingly, by performing a soft decision decoding for the repcated(n+t, k) Reed-Muller code through the IFHT, the same result is obtained by accumulating bits at repeated positions in the (n, k) Reed-Muller code and performing a soft decision decoding for the (n, k) Reed-Muller code through the IFHT. Also, for the soft decision decoding in the (n+t, k) Reed-Muller code, the same operation amount is necessary as that for the (n, k) Reed-Muller code.

As described above, when the Reed-Muller code is a punctured type Reed-Muller code, the 0 is inserted into the punctured position and the IFHT is performed. Also, when the Reed-Muller code is a repeated type Reed-Muller code, the repeated bits are accumulated and the IFHT is performed. In these ways, the soft decision decoding can be performed.

The above description employs an example in which a mask is not applied to the Reed-Muller code. However, when a mask is applied to the Reed-Muller code, the same operation is performed as that in the case of applying the IFHT, in consideration of the mask in the description of the prior art.

The present invention provides a method of performing a soft decision decoding of block codes having a predetermined number of information bits and a predetermined number of block bits utilizing the IFHT characteristic as described above, on an assumption that predetermined bits of a Reed-Muller code are punctured, repeated, or masked.

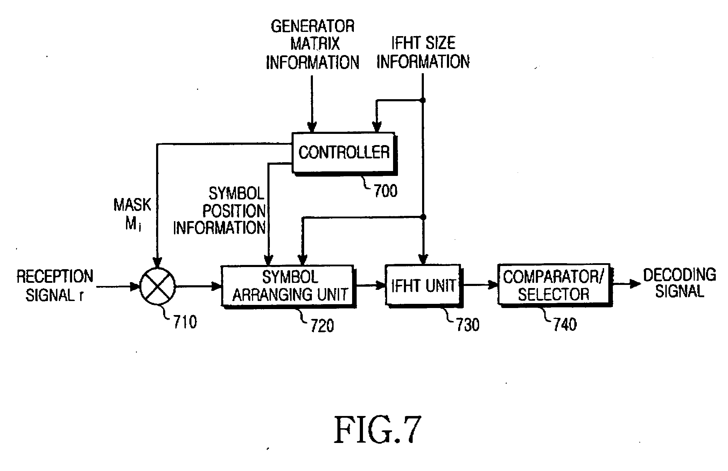

FIG 7 is a block diagram illustrating an internal structure of a soft decision decoding apparatus using an IFHT unit according to a first embodiment of the present invention. Referring to FIG. 7, the soft decision decoding apparatus according to the first embodiment of the present invention includes a controller 700, a mask multiplier 710, a symbol arranging unit 720, an IFHT unit 730, and a comparator/selector 740. Further, it is assumed that a generator matrix, which is applied to a transmitted or received block code in the first embodiment of the present invention and a second embodiment of the present invention to be described below, is identical to a matrix of Equation 3.

$$\text{Equation 3}$$
$$G = \begin{bmatrix} 10010000101 \\ 10100100001 \\ 00101100000 \\ 01001011110 \\ 00011000010 \\ 11000001010 \end{bmatrix}$$

The generator matrix is a $6 \times 11$ matrix, and a (11, 6) block code is generated when the generator matrix in Equation 3 is applied. Further, it is assumed that four highly-ranked bases from a first row to a fourth row arc used as an IFHT input from among six bases of the generator matrix G, and two low-ranked bases other than the four highly-ranked bases, that is, bases of fifth and sixth rows, are used as mask bases. Accordingly, because only four bases are used as the IFHT input, an input size of the IFHT for correlating the (11, 6) block code is 16 ($2^4$). In the first embodiment of the present invention, both a transmission side and a reception side recognize the IFHT size information and generator matrix information each other.

Further, as described above, the (11, 6) block code transmitted from the transmission side is received in the reception side in the form of a received signal r having noise and interference. The received signal r is expressed as r = r1r2r3r4r5r6r7r8r9r10r11, where r1 to r11 each refer to reception symbols.

The received signal r is transmitted to the mask multiplier 710. The mask multiplier 710 multiplies the received signal r by a mask M, output from the controller 700 and outputs a multiplication result to the symbol arranging unit 720. The controller 700 receives the IFHT size information and the generator matrix information related to the generator matrix from a main controller (not shown) of the reception side, and generates a mask $M_i$ and symbol position information utilizing the received generator matrix information and the IFHT size information. The controller 700 outputs the generated the mask $M_1$ and symbol position information to the mask multiplier 710 and the symbol arranging unit 720, respectively. Herein, because it is assumed that the two low-ranked bases of the generator matrix are used as the mask bases, the controller 700 defines the fifth row and the sixth row of the generator matrix as the mask bases $m_1$ and $m_2$, respectively. Accordingly, mask bases used as the mask are the $m_1$ basis, the $m_2$ basis, and an exclusive OR of the $m_1$ basis and the $m_2$ basis (hereinafter, referred to as $m_1 \oplus m_2$).

Also, because the soft decision decoding apparatus according to the first embodiment of the present invention has a serial structure, an all-one mask is additionally applied in order to constantly consider a hardware operation when a mask is not actually applied and the hardware operation when the mask is to be applied. That is, the controller 700 outputs the all-one mask to the mask multiplier 710, so that the present invention enables a structure actually having no mask to be taken into consideration, even with the same hardware structure having a mask. The $m_1$ mask basis, the $m_2$ mask basis, and the exclusive OR mask basis ($m_1 \oplus m_2$) are respectively modulated by a BPSK method to be used as masks.

As described in the prior art, because digital data is modulated by the BPSK method, the digital data 0 corresponds to +1 and the digital data 1 corresponds to -1. Further, as described in the prior art, when the mask has not been applied, the controller 700 does not output the all-one mask, and may bypass the operation of the mask multiplier 710.

As described in the prior art, the soft decision decoding apparatus using the IFHT may have a serial structure or a parallel structure. In the serial structure, the mask $M_1$ is sequentially processed. However, in the parallel structure, the mask $M_i$ is simultaneously processed at the same timing.

In the present invention, for convenience of description, only the soft decision decoding apparatus having the serial structure is described, but the present invention can be applied to the soft decision decoding apparatus having the parallel structure.

The symbol arranging unit 720 inputs the signal output from the mask multiplier 710 (i.e., the reception signal r), relocates positions of symbols constructing the reception signal r according to the symbol position information provided by the controller 700, and outputs the reception signal r to the IFHT unit 730. A more detailed description of a symbol position information decision process by the controller 700 and a symbol relocation process by the symbol arranging unit 720 will be described below.

The main controller transmits the IFHT size information to the controller 700 as well as the IFHT unit 730. The IFHT unit 730 constructs the input of the IFHT and the IFHT having a corresponding stage according to the IFHT size information transmitted from the main controller. Further, the IFHT unit 730 performs the IFHT for the signal output from the symbol arranging unit 720 to output an implementation result to the comparator/selector 740. The comparator/ selector 740 compares all IFHT result values output from the IFHT unit 730 with each other, selects a codeword having a maximum correlation value, and determines the selected codeword as a codeword transmitted from a transmission side. As a result, information bits corresponding to the codeword output from the comparator/selector 740 are restored as original information bits.

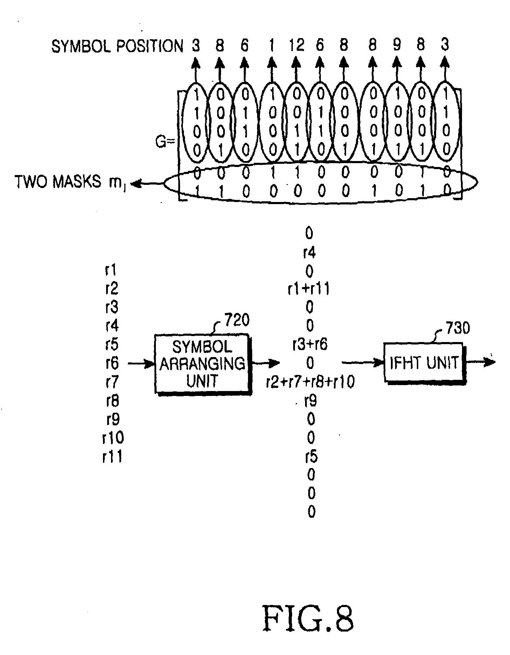

FIG. 8 is a view schematically illustrating a symbol position information decision process by the controller 700 and the symbol relocation process by the symbol arranging unit 720. Referring to FIG. 8, because it is assumed that the four highly-ranged bases from the first row to the fourth row of the generator matrix in Equation 3 are used for the IFHT input, sixteen ($2^4$) inputs are required as inputs of the IFHT unit 730. Herein, the number of inputs of the IFHT unit 730 is sixteen from 0 to 15. In the description below, for convenience, an input corresponding to the 0 is called the $0^{th}$ input and an input corresponding to the 15 is called the $15^{th}$ input. Actually, the $0^{th}$ input is a first input of the IFHT unit 730 and the $15^{th}$ input is a sixteen input of the IFHT unit 730.

Hereinafter, a process by which the controller 700 determines symbol position information of each symbol (i. e., r1, r2, r3, r4, r5, r6, r6, r7, r8, r9, r10, r11) constructing the reception signal r in order to consider the reception signal r (i.e., r1r2r3r4r5r6r7r8r9r10r11) as the input of the IFHT unit 730 will be described.

The controller 700 determines the symbol position by which each symbol of the reception signal r corresponds to the input of the IFHT unit 730 in regular sequence (i.e., sequentially from r1 to r11). The controller 700 selects only four highly-ranked bits of a first column of the generator matrix, generates a binary sequence 0011 in which an element of a first row is employed as an LSB and an element of a fourth row is employed as an MSB, and converts the binary sequence 0011 into a decimal number. When the binary sequence 0011 is converted into the decimal number, 3 is obtained. Accordingly, the controller 700 determines the symbol position in such a manner that the first symbol r1 of the reception signal r can be located at the third input of the IFHT unit 730 having an input size of 16 ($2^4$) (i.e., from 0 to 15).

Next, the controller 700 selects only four highly-ranked bits of a second column of the generator matrix, generate a binary sequence 1000 in which an element of a first row is employed as an LSB and an element of a fourth row is employed as an MSB, and converts the binary sequence 1000 into a decimal number. When the binary sequence 1000 is converted into the decimal number, 8 is obtained. Accordingly, the controller 700 determines the symbol position in such a manner that the second symbol r2 of the reception signal r can be located at the eighth input of the IFHT unit 730.

Further, the controller 700 selects only four highly-ranked bits of a third column of the generator matrix, generate a binary sequence 0110 in which an element of a first row is employed as an LSB and an element of a fourth row is employed as an MSB, and converts the binary sequence 0110 into a decimal number. When the binary sequence 0110 is converted into the decimal number, 6 is obtained. Accordingly, the controller 700 determines the symbol position in such a manner that the second symbol r3 of the reception signal r can be located at the sixth input of the IFHT unit 730. In this same way, the controller 700 determines the symbol positions in such a manner that the fourth symbol r4 to the eleventh symbol r11 of the reception signal r are located at corresponding inputs of the IFHT unit 730.

More specifically, as illustrated in FIG 8, the controller 700 determines the symbol positions of the first symbol r1 to the eleventh symbol r1 of the reception signal r in such a manner that the first symbol r1 of the reception signal r is located at the third input of the IFHT unit 730, the second symbol r2 of the reception signal r is located at the eighth input of the IFHT unit 730, the third symbol r3 of the reception signal r is located at the sixth input of the IFHT unit 730, the fourth symbol r4 of the reception signal r is located at the first input of the IFHT unit 730, the fifth symbol r5 of the reception signal r is located at the twelfth input of the IFHT unit 730, the sixth symbol r6 of the reception signal r is located at the sixth input of the IFHT unit 730, the seventh symbol r7 of the reception signal r is located at the eighth input of the IFHT unit 730, the eighth symbol r8 of the reception signal r is located at the eighth input of the IFHT unit 730, the ninth symbol r9 of the reception signal r is located at the ninth input of the IFHT unit 730, the tenth symbol r10 of the reception signal r is located at the eighth input of the IFHT unit 730, and the eleventh symbol r11 of the reception signal r is located at the third input of the IFHT unit 730.

Because the first symbol r1 and the eleventh symbol r11 of the reception signal r have the same decimal number (i.e., 3), the controller 700 determines the symbol position in such a manner that the first symbol r1 is added to the eleventh symbol r1 and r1+r11 is located at the third input of the IFHT unit 730. Further, because the third symbol r3 and the sixth symbol r6 of the reception signal r have the same decimal number (i.e., 6), the controller 700 determines the symbol position in such a manner that the third symbol r3 is added to the sixth symbol r6 and r3+r6 is located at the sixth input of the IFHT unit 730. Likewise, because the second symbol r2, the seventh symbol r7, the eighth symbol r8, and the tenth symbol r10 of the reception signal r have the same decimal number (i.e., 8), the controller 700 determines the symbol position in such a manner that the second symbol r2, the seventh symbol r7, the eighth symbol r8, and the tenth symbol r10 arc added to each other and r2+r7+r8+r10 is located at the eighth input of the IFHT unit 730.

The controller 700 generates the symbol position information according to the determined symbol positions to output the generated symbol position information to the symbol arranging unit 720. The symbol arranging unit 720 relocates each symbol of the reception signal r to the input of IFHT unit 730 according to the symbol position information output from the controller 700.

Hereinafter, a process by which the controller 700 generates the symbol position information will be described. The generator matrix is a $k \times n$ matrix. Further, it is assumed that (k-m) highly-ranked bases from k bases of the generator matrix are used as the IFHT input for performing the IFHT, and the other m low-ranked bases other than the (k-m) highly-ranked bases are used as mask bases.

An (n, k) block code generated according to the generator matrix is received in the reception side in the form of a received signal r having noise and interference on a channel, and the received signal r is expressed by an expression $r = r1\ r2 \cdots r(n-1)\ m$. The controller 700 selects only (k-m) bits of (k-m) highly-ranked rows from a first row to a $(k-m)^{th}$ row in each of the entire n columns sequentially from a first column to an $n^{th}$ column, generates binary sequences in which an element in the first row is employed as a LSB and an element in a $(k-m)^{th}$ row is employed as a MSB, and converts each of the generated binary sequences into decimal numbers. The controller 700 then determines symbol positions in such a manner that the first symbol r1 to the $n^{th}$ symbol m of the reception signal r are sequentially located at the inputs, which correspond to the converted decimal numbers, of the IFHT unit 730 having an input size of $2^{(k-m)}$. Herein, the number of inputs of the IFHT unit 730 is $2^{(k-m)}$ from 0 to $(2^{k-m}-1)$, an input corresponding to the 0 is called a $0^{th}$ input, and an input corresponding to the $(2^{k-m}-1)$ is called a $(2^{k-m}-1)^{th}$ input. However, actually, the $0^{th}$ input is a first input of the IFHT unit 730 and the $(2^{k-m}-1)^{th}$ input is a $2^{k-m}$ input of the IFHT unit 730. Further, when an $i^{th}$ column and a $j^{th}$ column have the same decimal number value "a" as each other, the controller 700 determines a symbol position in such a manner that a symbol $r_i + r_j$, which is obtained by adding an $i^{th}$ symbol $r_i$ of the reception signal r to a $j^{th}$ symbol $r_j$ of the reception signal r, is located at an $a^{th}$ input of the IFHT unit 730.

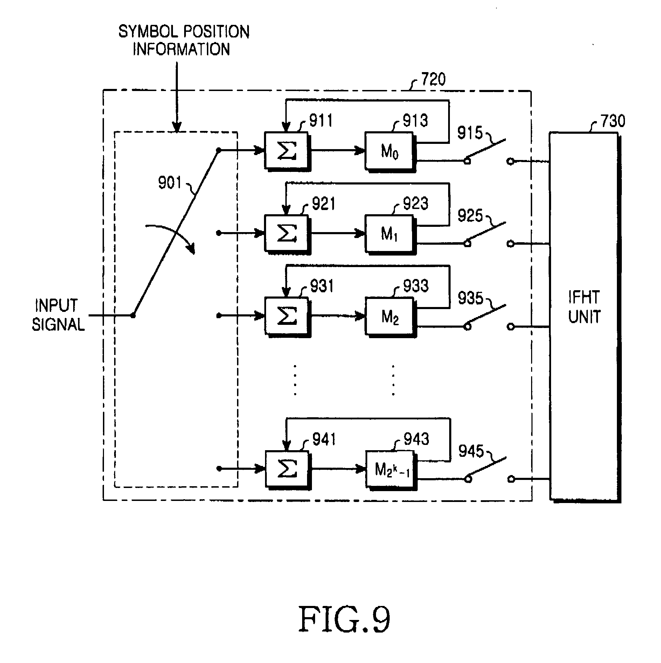

FIG. 9 is a view illustrating an internal structure of the symbol arranging unit 720 illustrated in FIG 7. The symbol arranging unit 720 relocates each symbol of the signal output from the mask multiplier 710 according to the symbol position information output from the controller 700, and provides the signal as the input of the IFHT unit 730. The symbol arranging unit 720 includes a switch 901, $2^{k-m}$ adders 911, 921, 931, $\cdots$, 941, $2^{k-m}$ memories 913, 923, 933, $\cdots$, 943, and, $2^{k-m}$ switches 915, 925, 935, $\cdots$, 945. Herein, each of the $2^{k-m}$ memories 913, 923, 933, $\cdots$, 943 is initialized to 0. An input signal, that is, the output signal of the mask multiplier 710 and the symbol position information are input to the symbol arranging unit 720. Hereinafter, for convenience of description, a case in which the mask multiplier 710 uses the all-one mask will be described as an example. However, when the all-one mask is applied, the same result is obtained as that when the all-one mask is not actually applied. When the mask $M_i$ is applied, only a mask value is multiplied by the reception signal r in the mask multiplier 710. Accordingly, the same symbol relocation process is performed as that when the mask $M_i$ is not applied.

Because it is assumed that the all-one mask has been applied to the reception signal r, the signal output from the mask multiplier 710 is identical to the reception signal r. As described above, the reception signal r is r1r2r3r4r5r6r7r8r9r10r11. When the reception signal r is input to the symbol arranging unit 720, the switch 901 connects each reception symbol of the reception signal r to a corresponding adder according to the symbol position information provided by the controller 700. For example, as described in FIG 8, because the symbol position information of the reception symbol r4 is 1 in decimal numbers, the switch 901 connects the r4 to the adder 921 located at front of the memory $M_1$ 923. Accordingly, the switch 901 connects each reception symbol to each adder located at front of a corresponding memory. Each of the $2^{k-m}$ adders 911, 921, 931, $\cdots$, 941 adds the signal connected by the switch 901 to a signal fedback from each of the $2^{k-m}$ memories 913, 923, 933, $\cdots$, 943, and outputs the added signal to each of the $2^{k-m}$ memories 913, 923, 933, $\cdots$, 943. Herein, whenever the signal is input, each of the $2^{k-m}$ memories 913, 923, 933, $\cdots$, 943 adds the signal, which is input through a feedback loop, to an existing stored signal, and stores a newly updated signal. Accordingly, when the switch 901 is not connected to each of the $2^{k-m}$ adders 911, 921, 931, $\cdots$, 941 located at front of each of the $2^{k-m}$ memories 913, 923, 933, $\cdots$, 943, because an newly input signal does not exist, each of the $2^{k-m}$ memories 913, 923, 933, $\cdots$, 943 maintains the existing stored signal intact.

Next, when the symbol relocation for each reception symbol of the reception signal r has been completed, the symbol arranging unit 720 controls switching of each of the $2^{k-m}$ switches 915, 925, 935, $\cdots$, 945 so that the signals, which have been stored from the memory $M_0$ 913 to the memory $M_{2^k-1}$ 943, are sequentially input to the IFHT unit 730, That is, the switch 915 connected to the memory $M_0$ 913 is first connected to the IFHT unit 730. In this way, the switch 945 connected to the memory $M_{2^k-1}$ 943 is finally connected to the IFHT unit 730. Then, the IFHT unit 730 sequentially inputs the signals stored from the memory $M_0$ 913 to the memory $M_{2^k-1}$ 943 to perform the IFHT for the input signals. I

In FIG. 9, a structure, in which each of the $2^{k-m}$ memories 913, 923, 933, ···, 943 is connected to each of the $2^{k-m}$ switches 915, 925, 935, ···, 945, has been described. However, instead of the $2^{k-m}$ switches 915, 925, 935, ···, 945, a parallel-to-serial converter may be used. That is, the parallel-to-serial converter performs a serial conversion for $2^{k-m}$ parallel inputs output from the $2^{k-m}$ memories 913, 923, 933, ···, 943 so that the output signal of the memory $M_0$ 913 is located at the very first, and outputs the converted signals to the IFHT unit 730.

Also, the IFHT unit 730 has $2^{k-m}$ inputs at maximum and performs h stage operations for an h (h≤k) utilizing $2^h$ inputs. Herein, the number of inputs of the IFHT unit 730 may be preset or may be adaptively changed according to circumstances. The IFHT unit 730 considers operation amount to determine the number of inputs. That is, as described above, the IFHT unit 730 needs the operation amount in $2^h \log_2 2^h$ plus processes in the course of decoding the (n, k) block code. When considering this, because the IFHT unit 730 has the minimum operation amount as the number of inputs is minimized, the IFHT unit 730 variably determines the number of inputs having the minimum operation amount. Hereinafter, a process by which the IFHT unit 730 determines the number of inputs will be described.

When the number $2^h$ of inputs of the IFHT unit 730 is determined, the number of mask functions used in the decoding apparatus is $2^{k-h}$. Accordingly, the total operation amount of the decoding apparatus is determined. Herein, the operation amount of the decoding apparatus is calculated with respect to all 'h's (0, h, k). A value of an 'h' having a minimum operation amount from among the 'h's is determined, so that the number of inputs of the IFHT unit 730 is determined as $2^h$. When the total operation amount of the decoding apparatus according to the value of the 'h' is considered, a portion by which the mask function is multiplied and a portion of performing the IFHT take the bulk of the total operation amount of the decoding apparatus. Herein, in consideration of the operation amount for multiplication between one input signal having a length of n bits and one mask, n multiplications and (n-1) additions are required. According to the assumption, $2^{k-h}$ masks are used according to the value of the 'h'. When the $2^{k-h}$ masks are multiplied by the input signal, the total operation amount is $2^{k-h}$ x n multiplication processes and $2^{k-h}$ x (n-1) plus processes. Further, because the operation amount in one IFHT unit needs $2^h \log_2 2^h$ (h·$2^h$) additions, and an IFHT operation in the entire decoding apparatus is performed as many as the number of the masks, the operation amount for the IFHT operation in the entire decoding apparatus is an h·$2^k$ (h·$2^h$ x $2^{k-h}$). Accordingly, the total operation amount of the decoding apparatus according to the value of the variable 'h' is $2^{k-h}$ x n multiplication processes and (n-1) ·$2^{k-h}$ + h·$2^k$ plus processes.

When it is assumed that the multiplication process has the same operation complexity as that of the plus process, the total operation amount is a (2n-1) ·$2^{k-h}$ + h·2 {n ·$2^{k-h}$+(n-1) ·$2^{k-h}$+h·$2^k$}. Accordingly, in determining the number of inputs of the IFHT unit in the decoding apparatus, the IFHT unit 730 calculates all operation amount values according to all possible 'h's (0, h, k), selects the 'h' having the smallest operation amount, and determines the number (i.e., size) of inputs of the IFHT.

In the first embodiment of the present invention, soft decision decoding has been described for when the main controller provides the IFHT size information and the generator matrix information . Hereinafter, the soft decision decoding will be described for when the main controller provides only generator matrix information.

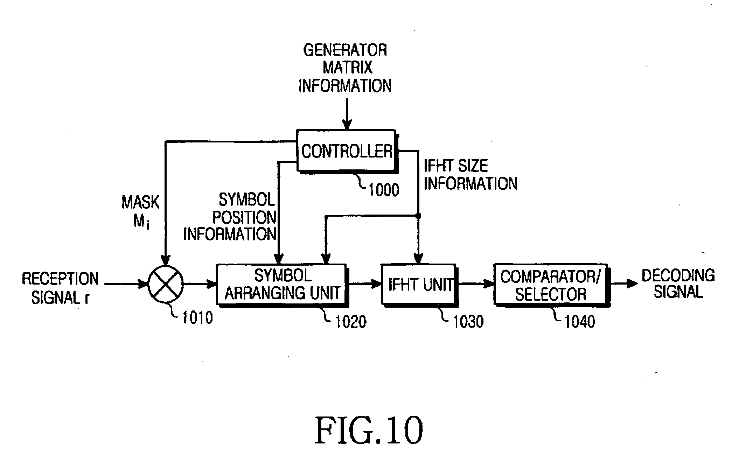

FIG. 10 is a block diagram illustrating an internal structure of a soft decision decoding apparatus using an IFHT unit according to a second embodiment of the present invention. Referring to FIG. 10, the soft decision decoding apparatus according to the second embodiment of the present invention includes a controller 1000, a mask multiplier 1010, a symbol arranging unit 1020, an IFHT unit 1030, and a comparator/selector 1040. Further, it is assumed that a generator matrix, which is applied to a transceived block code in the second embodiment of the present invention is identical to the matrix in Equation 3. The generator matrix in Equation 3 is a 6×11 matrix, and a (11, 6) block code is generated when the generator matrix in Equation 3 is applied. The controller 1000 receives generator matrix information related to the generator matrix from a main controller (not shown) of a reception side, and generates a mask $M_i$, symbol position information and IFHT size information utilizing the received generator matrix information. As a result, the difference between the first embodiment of present invention and the second embodiment of the present invention exists in operations performed by the controller of the soft decision decoding apparatus. That is, in the first embodiment of present invention, the controller 700 receives the generator matrix information and the IFHT size information from the main controller to determine the mask $M_i$ and the symbol position information, as described in FIG. 7. However, in the second embodiment of the present invention, the controller 1000 receives only generator matrix information from the main controller to generate the mask $M_i$, the symbol position information, and the IFHT size information.

The controller 1000 determines the number of inputs of the IFHT unit 1030 utilizing the generator matrix information received from the main controller, that is, determines the number of bases to be used as the inputs of the IFHT unit 1030. Hereinafter, a process by which the controller 1000 determines the number of inputs of the IFHT unit 1030 will be described.

When the number $2^h$ of inputs of the IFHT unit 730 is determined, the number of mask functions used in the decoding apparatus is $2^{k-h}$. Accordingly, the total operation amount of the decoding apparatus is determined. Herein, the operation amount of the decoding apparatus is calculated with respect to all 'h's (0, b, k). A value of an 'h' having a minimum operation amount from the 'h's is determined, so that the number of inputs of the IFHT unit 730 is determined as $2^h$. When the total operation amount of the decoding apparatus according to the value of a predetermined variable 'h' is considered, a portion by which the mask function is multiplied and a portion of performing the IFHT take the bulk of the total operation amount of the decoding apparatus. Herein, in consideration of the operation amount for multiplication between one input signal having a length of n bits and one mask, n multiplications and (n-1) additions arc required. According to the assumption, $2^{k-h}$ masks are used according to the value of the 'h'. When the $2^{k-h}$ masks are multiplied by the input signal, the total operation amount is $2^{k-h}$x n multiplication processes and $2^{k-h}$ x (n-1) plus processes. Further, because the operation amount in one IFHT unit needs $2^h\log_2 2^h$ (h-$2^h$) additions, and an IFHT operation in the entire decoding apparatus is performed as many as the number of the masks, the operation amount for the IFHT operation in the entire decoding apparatus is an h-$2^k$ (h-$2^h$ x $2^{k-h}$). Accordingly, the total operation amount of the decoding apparatus according to the value of the variable 'h' is 2 $^{k-h}$ x n multiplication processes and (n-1) $2^{k-h}$ + h.$2^k$ plus processes.

When it is assumed that the multiplication process has the same operation complexity as that of the plus process, the total operation amount is (2n-1) ·$2^{k-h}$ + h·$2^k$ {n ·$2^{k-h}$+(n-1) ·$2^{k-h}$+h·$2^k$}. Accordingly, in determining the number of inputs of the IFHT unit in the decoding apparatus, the IFHT unit 1030 calculates all operation amount values according to all possible 'h's (0, h, k), selects the 'h' having the smallest operation amount, and determines the number (i.e., size) of inputs of the IFHT.

The controller 1000 considers the operation amount, system complexity, and IFHT implementation time, etc., when the IFHT is performed, and determines the number of inputs of the IFHT. That is, the controller 1000 determines the number having the minimum operation amount, the minimum system complexity, and the minimum IFHT implementation time as the number of inputs of the IFHT. For example, when the generator matrix is a k×n matrix, a (n, k) block code is generated from the k×n matrix. When one basis from k bases of the k×n matrix is used as an input of the IFHT and (k-1) bases from k bases of the k×n matrix are used as mask bases, an operation in one stage is performed for $2^1$ inputs in the IFHT, and the soft decision decoding is repeatedly performed for the total $2^{k-1}$ mask bases.

In FIG 10, it is assumed that three highly-ranked bases from a first row to a third row from six bases of the generator matrix in equation 3 are used as an IFHT input for performing the IFHT, and the other three low-ranked bases other than the three highly-ranked bases, that is, bases of a fourth row and a sixth row, arc used as mask bases. The controller 1000 outputs the mask M, corresponding to the determined mask bases to the mask multiplier 1010, determines the symbol position information of each reception symbol of a reception signal r according to the determined number of inputs of the IFHT, thereby outputting the symbol position information to the symbol arranging unit 1020. Further, the controller 1000 outputs the IFHT size information to the symbol arranging unit 1020 and the IFHT unit 1030.

Herein, because it is assumed that the three low-ranked bases of the generator matrix arc used as the mask bases, the controller 1000 defines the fourth row and the sixth row of the generator matrix as a first mask basis $m_1$ to a third mask basis $m_3$, respectively. Accordingly, mask bases used as the mask are the $m_1$ basis, the $m_2$ basis, an exclusive OR of the $m_1$ basis and the $m_2$ basis (hereinafter, referred to as $m_1 \oplus m_2$), an exclusive OR of the $m_1$ basis and the $m_3$ basis (hereinafter, referred to as $m_1 \oplus m_3$), an exclusive OR of the $m_2$ basis and the $m_3$ basis (hereinafter, referred to as $m_2 \oplus m_3$), and an exclusive OR of the $m_1$ basis, the $m_2$ basis, and the $m_3$ basis (hereinafter, referred to as $m_1 \oplus m_2 \oplus m_3$).

Also, because the soft decision decoding apparatus according to the second embodiment of the present invention has a serial structure, an all-one mask is additionally applied in order to constantly consider a hardware operation when a mask is not actually applied and the hardware operation when the mask is to be applied. That is, the controller 1000 outputs the all-one mask to the mask multiplier 1010, so that the present invention enables a structure actually having no mask to be taken into consideration, even with the same hardware structure having a mask. The $m_1$ mask basis, the $m_2$ mask basis, and the exclusive OR mask basis ($m_1 \oplus m_2$), exclusive OR ($m_1 \oplus m_3$), an exclusive OR ($m_2 \oplus m_3$), and an exclusive OR ($m_1 \oplus m_2 \oplus m_3$), the $m_2$ basis, and the $m_3$ basis are respectively modulated by a BPSK method to be used as masks.

As described in the prior art, because digital data is modulated by the BPSK method, digital data 0 corresponds to +1 and digital data 1 corresponds to - 1. Further, as described in the prior art, when the mask has not been applied, the controller 1000 does not output the all-one mask, and may bypass the operation of mask multiplier 1010.

As described in the prior art, the soft decision decoding apparatus using the IFHT may have a serial structure or a parallel structure. In the present invention, for convenience of description, because only the soft decision decoding apparatus having the serial structure is described, the soft decision decoding apparatus in FIG. 10 also has the parallel structure. Then, when the reception signal r is received, the controller 1000 outputs the all-one mask to the mask multiplier 1010 on an assumption that the all-one mask has been initially applied. The mask multiplier 1010 multiplies the reception signal r by the all-one mask, and outputs the multiplication result to the symbol arranging unit 1020. The symbol arranging unit 1020 inputs the signal output from the mask multiplier 1010 (i.e., the reception signal r), relocates positions of symbols constructing the reception signal r according to the symbol position information provided by the controller 1000, and outputs the reception signal r to the IFHT unit 1030.

The IFHT unit 1030 constructs the input of the IFHT and the IFHT having a corresponding stage according to the IFHT size information transmitted from the controller 1000. Further, the IFHT unit 1030 performs the IFHT for the signal output from the symbol arranging unit 1020 to output an implementation result to the comparator/selector 1040. The comparator/selector 1040 compares all IFHT result values output from the IFHT unit 1030 with each other, and selects a codeword having a maximum correlation value. Accordingly, the comparator/selector 1040 determines the selected codeword as a codeword transmitted from a transmission side. As a result, information bits corresponding to the codeword output from the comparator/selector 1040 are restored as original information bits.

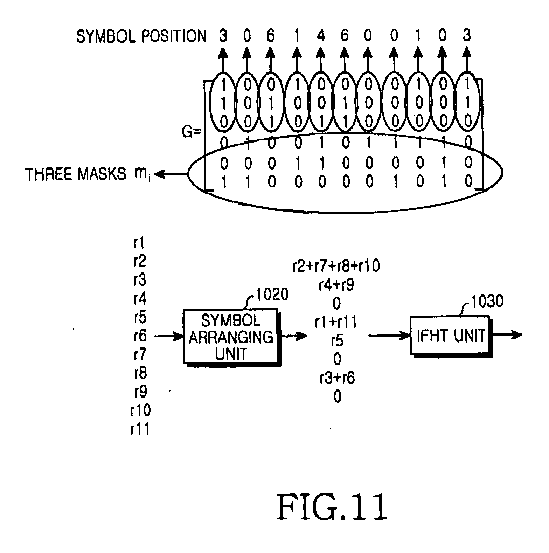

FIG. 11 is a view schematically illustrating a symbol position information decision process by the controller 1000 and the symbol relocation process by the symbol arranging unit 1020. Referring to FIG. 11, because the controller 1000 has determined that the three highly-ranked bases from the first row to the third row of the generator matrix in equation 3 are used for the IFHT input, eight ($2^3$) inputs are required as inputs of the IFHT unit 1030. Herein, the number of inputs of the IFHT unit 1030 is eight from 0 to 7. In the below description, for convenience of description, an input corresponding to the 0 is called the $0^{th}$ input and an input corresponding to the 7 is called the $7^{th}$ input. However, actually, the $0^{th}$ input is a first input of the IFHT unit 1030 and the $7^{th}$ input is an eighth input of the IFHT unit 1030. Hereinafter, a process by which the controller 1000 determines symbol position information of each symbol (i.e., r1, r2, r3, r4, r5, r6, r6, r7, r8, r9, r10, r11) constructing the reception signal r in order to consider the reception signal r (i. e., r1r2r3r4r3r6r7r8r9r10r11) as the input of the IFHT unit 1030 will be described.

The controller 1000 determines the symbol position by which each symbol of the reception signal r corresponds to the input of the IFHT unit 1030 in regular sequence (i.e., sequentially from r1 to r11). The controller 1000 takes only three highly-ranked bits of a first column of the generator matrix, generates a binary sequence 011 in which an element of a first row is employed as an LSB and an element of a third row is employed as an MSB, and converts the binary sequence 011 into a decimal number. When the binary sequence 011 is converted into the decimal number, 3 is obtained. Accordingly, the controller 1000 determines the symbol position in such a manner that the first symbol r1 of the reception signal r is located at the third input of the IFHT unit 1030 having an input size of eight ($2^3$) (i.e., from 0 to 7).

Next, the controller 1000 takes only three highly-ranked bits of a second column of the generator matrix, generates a binary sequence 000 in which an clement of a first row is employed as an LSB and an element of a third row is employed as an MSB, and converts the binary sequence 000 into a decimal number. When the binary sequence 000 is converted into the decimal number, 0 is obtained. Accordingly, the controller 1000 determines the symbol position in such a manner that the second symbol r2 of the reception signal r is located at the $0^{th}$ input of the IFHT unit 1030.

Further, the controller 1000 takes only three highly-ranked bits of a third column of the generator matrix, generates a binary sequence 110 in which an element of a first row is employed as an LSB and an element of a third row is employed as an MSB, and converts the binary sequence 110 into a decimal number. When the binary sequence 110 is converted into the decimal number, 6 is obtained. Accordingly, the controller 1000 determines the symbol position in such a manner that the second symbol r3 of the reception signal r is located at the sixth input of the IFHT unit 1030.

Likewise, the controller 1000 determines the symbol positions in such a manner that the fourth symbol r4 to the eleventh symbol r11 of the reception signal r are located at corresponding inputs of the IFHT unit 1030. That is, as illustrated in FIG 11, the controller 1000 determines the symbol positions of the first symbol r1 to the eleventh symbol r11 of the reception signal r in such a manner that that the first symbol r1 of the reception signal r is located at the third input of the IFHT unit 1030, the second symbol r2 of the reception signal r is located at the $0^{th}$ input of the IFHT unit 1030, the third symbol r3 of the reception signal r is located at the sixth input of the IFHT unit 1030, the fourth symbol r4 of the reception signal r is located at the first input of the IFHT unit 1030, the fifth symbol r5 of the reception signal r is located at the fourth input of the IFHT unit 1030, the sixth symbol r6 of the reception signal r is located at the sixth input of the IFHT unit 1030, the seventh symbol r7 of the reception signal r is located at the $0^{th}$ input of the IFHT unit 1030, the eighth symbol r8 of the reception signal r is located at the $0^{th}$ input of the IFHT unit 1030, the ninth symbol r9 of the reception signal r can be located at the first input of the IFHT unit 1030, the tenth symbol r10 of the reception signal r is located at the $0^{th}$ input of the IFHT unit 1030, and the eleventh symbol r11 of the reception signal r is located at the third input of the IFHT unit 1030. Also, the controller 1000 outputs the symbol position information according to the determined symbol positions to the symbol arranging unit 1020.

Because the second symbol r2, the seventh symbol r7, the eighth symbol r8, and the tenth symbol r10 of the reception signal r have the same decimal number (i.e., 0), the controller 1000 determines the symbol position in such a manner that the second symbol r2, the seventh symbol r7, the eighth symbol r8, and the tenth symbol r10 are added to each other, and r2+r7+r8+r10 is located at the $0^{th}$ input of the IFHT unit 1030. Further, because the fourth symbol r4 and the ninth symbol r9 of the reception signal r have the same decimal number (i.e., 1), the controller 1000 determines the symbol position in such a manner that the fourth symbol r4 is added to the ninth symbol r9 and r4+r9 is located at the first input of the IFHT unit 1030. Further, because the first symbol r1 and the eleventh symbol r11 have the same decimal number (i.e., 3), the controller 1000 determines the symbol position in such a manner that the first symbol r1 is added to the eleventh symbol r11 and r1+r1 is located at the third input of the IFHT unit 1030. Further, because the third symbol r3 and the sixth symbol r6 have the same decimal number (i.e., 6), the controller 1000 determines the symbol position in such a manner that the third symbol r3 is added to the sixth symbol r6 and r3+r6 is located at the sixth input of the IFHT unit 1030.

Additionally, the symbol arranging unit 1020 according to the second embodiment of the present invention has the same structure as that of the symbol arranging unit 720 illustrated in FIG 9, but has a different number of inputs of the IFHT 1030 than the IFHT 730. That is, the symbol arranging unit 1020 has the number of memories connected at front of the IFHT 1030, the number of adders connected to the memories, and the number of switches connected to the memories different from those in the symbol arranging unit 720.

As described above, the present invention is advantageous in that an IFHT is controlled to be performed for a block code having predetermined information bit length and block length through a symbol relocation, so that a soft decision decoding having the minimum operation amount can be performed. Further, in the present invention, the number of bases to be used as an input of the IFHT and the number of bases to be used as a mask are determined according to a generator matrix of the block code, so that the soft decision decoding having the minimum operation amount, the minimum system complexity, and the minimum IFHT implementation time can be performed.

Furthermore, in the present invention, the soft decision decoding is controlled according to the generator matrix when it is performed for the block code having predetermined information bit length and block length as described above. Therefore, the present invention has an advantage in that the block codes having different lengths can be decoded through a soft decision decoding apparatus having the same hardware structure.

While the present invention has been shown and described with reference to certain preferred embodiments thereof, it will be understood by those skilled in the art that various changes in form and details may be made therein without departing from the spirit and scope of the present invention as defined by the appended claims.

## Claims

1. An apparatus for decoding n reception symbols utilizing block code generator matrix information, the apparatus comprising:

   a controller for determining symbol position information for relocating each of the n reception symbols utilizing the block code generator matrix information and inverse fast hadamard transform (IFHT) size information for performing an IFHT for the n reception symbols;
   a symbol arranging unit for relocating each of the n reception symbols according to the symbol position information determined by the controller;
   an IFHT unit for inputting the symbols relocated by the symbol arranging unit to perform the IFHT for the symbols; and
   a comparator/selector for outputting, as a decoding signal, a codeword of a block code having a maximum correlation value from among result values obtained by performing the IFHT.

2. The apparatus as claimed in claim 1, wherein the block code generator matrix information represent a $k \times n$ matrix, which has k rows and n columns, for generating the block code, and the IFHT size information is information for controlling bases in k-m highly-ranked rows in the $k \times n$ matrix to be used as input of the IFHT unit.

3. The apparatus as claimed in claim 2, wherein the controller sequentially selects elements from the $k \times n$ matrix by selecting only k-m elements from a first row to an $(k\text{-}m)^{th}$ row in each of the n columns sequentially from a first column to an $n^{th}$ column, generates binary sequences in which an element in the first row is used as a least significant bit and an clement in the m-th row is used as a most significant bit, and calculates decimal numbers of each of the generated binary sequences, so that the controller determines the symbol position information in such a manner that a first reception symbol to an $n^{th}$ reception symbol of the reception symbols sequentially correspond to the inputs of the IFHT unit, which correspond to decimal values in the n columns from the first column to the $n^{th}$ column, respectively.

4. The apparatus as claimed in claim 2, wherein the apparatus further comprises a mask multiplier for multiplying the n reception symbols by masks provided according to a predetermined control, and outputting the multiplication results to the symbol arranging unit.

5. The apparatus as claimed in claim 4, wherein the controller uses bases in a row-ranked m row, not including bases in a highly-ranked k-m row, in the $k \times n$ matrix as mask bases, and provides masks, which are generated by modulating the mask bases according to a modulation method applied to the block code, to the mask multiplier.

6. The apparatus as claimed in claim 3, wherein the symbol arranging unit comprises:

a switch for inputting the reception symbols, and switching respectively a first reception symbol to an $n^{th}$ reception symbol to n adders according to the symbol position information provided by the controller;
n memories respectively connected to n inputs from a first input to an $n^{th}$ input of the IFHT unit; and
n adders having first ends and second ends, each of the first ends being connected to the switch, and each of the second ends being connected to each of the respective n memories.

7. The apparatus as claimed in claim 6, wherein the symbol arranging unit further comprises:

n switches, each of the n switches having a first end and a second end, the first end being connected to one of the n memories, the second end being connected to the IFHT unit,

wherein the symbol arranging unit controls the n switches to be sequentially connected to the IFHT unit, sequentially from a switch connected to the first input of the IFHT unit to a switch connected to the $n^{th}$ input of the IFHT unit, when a symbol relocation for each of the n reception symbols has been completed.

8. The apparatus as claimed in claim 6, wherein the symbol arranging unit further comprises:

a parallel-to-serial converter having a first end and a second end, the first end being connected to each of the n memories, the second end being connected to the IFHT unit,

wherein the symbol arranging unit controls the parallel-to-serial converter to perform serial conversion for signals stored in the n memories and output the converted signals to the IFHT unit, sequentially from a memory connected to the first input to a memory connected to the $n^{th}$ input of the IFHT unit, when the symbol relocation for each of the n reception symbols has been completed.

9. An apparatus for decoding a block code including n reception symbols utilizing block code generator matrix information, the apparatus comprising:

a controller for determining inverse fast hadamard transform (IFHT) size information for performing an IFHT for the n reception symbols and symbol position information for relocating each of the n reception symbols utilizing the block code generator matrix information;
a symbol arranging unit for relocating each of the n reception symbols according to the symbol position information determined by the controller;
an IFHT unit for inputting the symbols relocated by the symbol arranging unit to perform the IFHT for the symbols; and
a comparator/selector for outputting, as a decoding signal, a codeword of the block code, which has a maximum correlation value from among result values obtained by performing the IFHT.

10. The apparatus as claimed in claim 9, wherein the block code generator matrix information represent a k×n matrix, which has k rows and n columns, for generating the block code.

11. The apparatus as claimed in claim 9, wherein the controller considers operation amount, system complexity, and IFHT implementation time when the IFHT is performed utilizing the block code generator matrix information, and uses the IFHT size information, and the IFHT size information control bases in k-m highly-ranked rows in the k×n matrix to be used as input of the IFHT unit.

12. The apparatus as claimed in claim 11, wherein the controller sequentially selects elements from the k×n matrix by selecting only m elements of the k-m highly-ranked rows from a first row to an $(k-m)^{th}$ row in each of the n columns sequentially from a first column to an $n^{th}$ column, generates binary sequences in which an element in the first row is used as a least significant bit and an element in the m-th row is used as a most significant bit, and calculates decimal numbers of each of the generated binary sequences, so that the controller determines the symbol position information in such a manner that a first reception symbol to an $n^{th}$ reception symbol of the reception symbols sequentially correspond to the inputs of the IFHT unit, which correspond to decimal values in the n columns from the first column to the $n^{th}$ column, respectively.

**13.** The apparatus as claimed in claim 11, wherein the apparatus further comprises a mask multiplier for multiplying the reception symbols by masks provided according to a predetermined control, and for outputting the multiplication results to the symbol arranging unit.

**14.** The apparatus as claimed in claim 13, wherein the controller uses bases in a row-ranked m row, not including bases in a highly-ranked k-m row, in the k×n matrix as mask bases, and provides masks, which are generated by modulating the mask bases according to a modulation method applied to the block code, to the mask multiplier.

**15.** The apparatus as claimed in claim 12, wherein the symbol arranging unit comprises:

a switch for inputting the reception symbols, and switching respectively a first reception symbol to an $n^{th}$ reception symbol to n adders according to the symbol position information provided by the controller;
n memories respectively connected to n inputs from a first input to an $n^{th}$ input of the IFHT unit; and
n adders having first ends and second ends, each of the first ends being connected to the switch, and each of the second ends being connected to each of the respective n memories.

**16.** The apparatus as claimed in claim 15, wherein the symbol arranging unit further comprises:

n switches, each of the n switches having a first end and a second end, the first end being connected to one of the n memories, the second end being connected to the IFHT unit,

wherein the symbol arranging unit controlling the n switches to be sequentially connected to the IFHT unit, sequentially from a switch connected to the first input of the IFHT unit to a switch connected to the $n^{th}$ input of the IFHT unit, when a symbol relocation for each of the n reception symbols has been completed.

**17.** The apparatus as claimed in claim 15, wherein the symbol arranging unit further comprises:

a parallel-to-serial converter having a first end and a second end, the first end being connected to each of the n memories, the second end being connected to the IFHT unit,

wherein the symbol arranging unit controls the parallel-to-serial converter to perform serial conversion for signals stored in the n memories and output the converted signals to the IFHT unit, sequentially from a memory connected to the first input to a memory connected to the $n^{th}$ input of the IFHT unit, when the symbol relocation for each of the n reception symbols has been completed.

**18.** A method for decoding n reception symbols utilizing block code generator matrix information, the method comprising the steps of:

a) determining symbol position information for relocating each of the n reception symbols utilizing the block code generator matrix information and inverse fast hadamard transform (IFHT) size information for performing an IFHT for the n reception symbols;
b) relocating each of the n reception symbols as an input of an IFHT unit according to the determined symbol position information;
c) inputting the relocated symbols to perform the IFHT for the symbols; and
d) outputting, as a decoding signal, a codeword of a block code, which has a maximum correlation value from among result values obtained by performing the IFHT.

**19.** The method as claimed in claim 18, wherein the block code generator matrix information represent a k×n matrix, which has k rows and n columns, for generating the block code, and the IFHT size information is information for controlling bases in k-m highly-ranked rows in the k×n matrix to be used as input of the IFHT unit.

**20.** The method as claimed in claim 19, wherein said step a) comprises:

selecting elements from the k×n matrix by selecting only m elements of the k-m highly-ranked rows from a first row to an $(k-m)^{th}$ row in each of the n columns sequentially from a first column to an $n^{th}$ column in the k×n matrix;
generating binary sequences in which an element in a first row is used as a least significant bit and an element in an $(k-m)^{th}$ row is used as a most significant bit;

calculating a decimal number value of each of the generated binary sequences; and
determining the symbol position information so that a first reception symbol to an $n^{th}$ reception symbol of the reception symbols sequentially correspond to the inputs of the IFHT, which correspond to decimal values in the n columns from the first column to the $n^{th}$ column.

21. The method as claimed in claim 19, further comprising the steps of:

multiplying the reception symbols by masks provided according to a predetermined control; and
relocating the symbols.

22. The method as claimed in claim 21, wherein the masks are generated by modulating bases in a row-ranked m row, not including bases in a highly-ranked (k-m) row, in the k×n matrix according to a modulation method applied to the block code.

23. A method for decoding n reception symbols utilizing block code generator matrix information, the method comprising the steps of:

a) determining inverse fast hadamard transform (IFHT) size information for performing an IFHT for the n reception symbols and symbol position information for relocating each of the n reception symbols utilizing the block code generator matrix information;
b) relocating each of the n reception symbols as an input of an IFHT unit according to the determined symbol position information;
c) inputting the relocated symbols to perform the IFHT for the symbols; and
d) outputting, as a decoding signal, a codeword of a block code, which has a maximum correlation value from among result values obtained by performing the IFHT.

24. The method as claimed in claim 23, wherein the block code generator matrix information represent a k×n matrix, which has k rows and n columns, for generating the block code.

25. The method as claimed in claim 23, wherein the IFHT size information is determined by considering operation amount, system complexity, and IFHT implementation time when the IFHT is performed utilizing the block code generator matrix information, and the IFHT size information is information for controlling bases in (k-m) highly-ranked rows in the k×n matrix to be used as the input of the IFHT unit.

26. The method as claimed in claim 25, wherein said step a) comprises the steps of:

selecting elements from the k×n matrix by selecting only m elements of the (k-m) highly-ranked rows from a first row to an (k-m)$^{th}$ row in each of the n columns sequentially from a first column to an $n^{th}$ column in the k×n matrix;
generating binary sequences in which an element in a first row is used as a least significant bit and an element in an (k-m)$^{th}$ row is used as a most significant bit;
calculating a decimal number value of each of the generated binary sequences;and
determining the symbol position information so that a first reception symbol to an $n^{th}$ reception symbol of the reception symbols sequentially correspond to the inputs of the IFHT, which correspond to decimal values in the n columns from the first column to the $n^{th}$ column.

27. The method as claimed in claim 25, further comprising the steps of:

multiplying the reception symbols by masks provided according to a predetermined control; and
relocating the symbols.

28. The method as claimed in claim 27, wherein the masks are generated by modulating bases in a row-ranked m row, not including bases in a highly-ranked k-m row, in the k×n matrix according to a modulation method applied to the block code.

29. An apparatus for decoding n reception symbols utilizing a block code generator matrix having k rows and n columns, the apparatus comprising:

a controller for inputting the n reception symbols and calculating symbol positions for the n columns in the block code generator matrix; and
a symbol arranging unit including adders for accumulating and relocating the n reception symbols at the calculated symbol positions.

**30.** The apparatus as claimed in claim 29, wherein the apparatus further comprises:

an inverse fast hadamard transform (IFHT) unit for inputting the accumulated symbols by the symbol arranging unit and performing an IFHT for the symbols: and
a comparator/selector for decoding n bits, which have a maximum correlation value from among results obtained by performing the IFHT, as information bits.

**31.** The apparatus as claimed in claim 30, wherein the apparatus further comprises a mask multiplier for multiplying the n reception symbols by masks provided according to a predetermined control, and outputting the multiplication result to the symbol arranging unit.

**32.** The apparatus as claimed in claim 31, wherein the controller uses bases in a row-ranked m row, not including bases in a highly-ranked (k-m) row, in the block code generator matrix as mask bases, and provides masks, which are generated by modulating the mask bases according to a modulation method applied to a block code, to the mask multiplier.

**33.** A method for decoding n reception symbols utilizing a block code generator matrix having k rows and n columns, the method comprising the steps of:

calculating symbol positions for the n columns in the block code generator matrix; and
accumulating and relocating the n reception symbols at the calculated symbol positions.

**34.** The method as claimed in claim 33, further comprising the steps of:

inputting the accumulated symbols and performing an inverse fast hadamard transform (IFHT) for the symbols: and
decoding n bits, which have a maximum correlation value from among results obtained by performing the IFHT, as information bits.

**35.** The method as claimed in claim 34, further comprising the steps of:

multiplying the n reception symbols by masks provided according to a predetermined control; and
relocating the symbols to the calculated symbol positions.

**36.** The method as claimed in claim 35, wherein the masks are generated by modulating bases in a row-ranked m row, not including bases in a highly-ranked (k-m) row, in the block code generator matrix according to a modulation method applied to a block code.

RECEPTION SIGNAL r → CORRELATOR /100 → COMPARATOR/ SELECTOR /110 → DECODING SIGNAL

# FIG.1

CONTROLLER /200

MASK $M_i$

RECEPTION SIGNAL r → ⊗ /210 → IFHT UNIT /220 → COMPARATOR/ SELECTOR /230 → DECODING SIGNAL

# FIG.2

RECEPTION
SIGNAL r

IFHT UNIT  _311_

321
⊗ ── IFHT UNIT  _323_
↑
M₁

331
⊗ ── IFHT UNIT  _333_
↑
M₂

341
⊗ ── IFHT UNIT  _343_
↑
M₁ ⊕ M₂

350
COMPARATOR/
SELECTOR ──→ DECODING
SIGNAL

# FIG.3

| Stage 1 | Stage 2 | Stage 3 |
|---------|---------|---------|

| r1 | r1+r2 | (r1+r2) + (r3+r4) | ((r1+r2) + (r3+r4)) + ((r5+r6) + (r7+r8)) |
|----|-------|-------------------|-------------------------------------------|
| r2 | r1−r2 | (r1−r2) + (r3−r4) | ((r1−r2) + (r3−r4)) + ((r5−r6) + (r7−r8)) |
| r3 | r3+r4 | (r1+r2) − (r3+r4) | ((r1+r2) − (r3+r4)) + ((r5+r6) − (r7+r8)) |
| r4 | r3−r4 | (r1−r2) − (r3−r4) | (r1−r2) − (r3−r4)) + ((r5−r6) − (r7−r8)) |
| r5 | r5+r6 | (r5+r6) + (r7+r8) | ((r1+r2) + (r3+r4) − ((r5+r6) + (r7+r8)) |
| r6 | r5−r6 | (r5−r6) + (r7−r8) | ((r1−r2) + (r3−r4)) − ((r5−r6) + (r7−r8)) |
| r7 | r7+r8 | (r5+r6) − (r7+r8) | ((r1+r2) − (r3+r4)) − ((r5+r6) − (r7+r8)) |
| r8 | r7−r8 | (r5−r6) − (r7−r8) | (r1−r2) − (r3−r4) − ((r5−r6) − (r7−r8)) |

# FIG.4

FIG.5

FIG.6

FIG.7

FIG.8

FIG.9

FIG.10

SYMBOL POSITION 3 0 6 1 4 6 0 0 1 0 3

$$
G=
\begin{matrix}
1 & 0 & 0 & 1 & 0 & 0 & 0 & 0 & 1 & 0 & 1 \\
1 & 0 & 1 & 0 & 0 & 1 & 0 & 0 & 0 & 0 & 1 \\
0 & 0 & 1 & 0 & 1 & 1 & 0 & 0 & 0 & 0 & 0 \\
0 & 1 & 0 & 0 & 1 & 0 & 1 & 1 & 1 & 1 & 0 \\
0 & 0 & 0 & 1 & 1 & 0 & 0 & 0 & 0 & 1 & 0 \\
1 & 1 & 0 & 0 & 0 & 0 & 0 & 1 & 0 & 1 & 0
\end{matrix}
$$

THREE MASKS $m_i$

r1
r2
r3
r4
r5
r6 →
r7
r8
r9
r10
r11

1020
SYMBOL ARRANGING UNIT →

r2+r7+r8+r10
r4+r9
0
r1+r11
r5
0
r3+r6
0

1030
IFHT UNIT →

# FIG.11